(19) Europäisches Patentamt
European Patent Office
Office européen des brevets

(11) EP 2 608 270 A2

(12) EUROPEAN PATENT APPLICATION

(43) Date of publication:
26.06.2013 Bulletin 2013/26

(51) Int Cl.:
H01L 29/778 (2006.01)          H01L 21/338 (2006.01)
H01L 29/36 (2006.01)           H01L 29/205 (2006.01)

(21) Application number: 12184232.2

(22) Date of filing: 13.09.2012

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 21.12.2011  JP 2011280527

(71) Applicant: FUJITSU LIMITED
Kawasaki-shi,
Kanagawa 211-8588 (JP)

(72) Inventor: Endoh, Akira
Kawasaki-shi, Kanagawa 211-8588 (JP)

(74) Representative: Lewin, David Nicholas
Haseltine Lake LLP
Lincoln House, 5th Floor
300 High Holborn
London WC1V 7JH (GB)

(54) **Semiconductor device and method of manufacturing the same**

(57)  A semiconductor device includes a carrier transit layer above a substrate, a carrier supply layer above the carrier transit layer, an etching stopper layer above the carrier supply layer, the etching stopper layer being coupled to a gate electrode, and a cap layer above the etching stopper layer, the cap layer being coupled to each of a source electrode and a drain electrode and having a conduction band energy lower than that of the etching stopper layer, wherein a portion of the etching stopper layer on the cap layer includes Silicon.

FIG. 2

**Description**

FIELD

The embodiments discussed herein are related to a semiconductor device and a method of manufacturing the semiconductor device.

BACKGROUND

In order to operate semiconductor devices at higher speed, the delay time of signals is preferably shortened. For example, in high electron mobility transistors (HEMTs), the gate length has been further decreased to shorten the delay time for the purpose of achieving high speed operation or the material of a channel layer through which electrons pass has been improved to increase the speed of electrons.

Examples of the related art include Seong-Jin Yeon et al., "610 GHz InAlAs/In0.75GaAs Metamorphic HEMTs with an Ultra-Short 15-nm-Gate", IEDM Technical Digest, pp. 613 to 616 (2007); Dae-Hyun Kim et al., "30-nm InAs PHEMTs With fT = 644 GHz and fmax = 681 GHz", IEEE Electron Device Letters, Vol. 31, No. 8, August 2010, pp. 806 to 808; and A. Leuther et al., "20 NM METAMORPHIC HEMT WITH 660 GHz FT", Proc. IPRM 2011 (International Conference of Indium Phosphide and Related Materials 2011), pp. 295 to 298 (2011).

It is an object of the disclosed technology to provide a semiconductor device that may achieve high-speed signal transmission and a method for manufacturing the semiconductor device.

SUMMARY

According to an aspect of the invention, a semiconductor device includes a carrier transit layer above a substrate, a carrier supply layer above the carrier transit layer, an etching stopper layer above the carrier supply layer, the etching stopper layer being coupled to a gate electrode, and a cap layer above the etching stopper layer, the cap layer being coupled to each of a source electrode and a drain electrode and having a conduction band energy lower than that of the etching stopper layer, wherein a portion of the etching stopper layer on the cap layer includes Silicon.

BRIEF DESCRIPTION OF DRAWINGS

FIG. 1 is a plan view illustrating an example of a semiconductor device according to this embodiment;

FIG. 2 is a sectional view taken along alternate long and short dashed line II-II illustrated in FIG. 1;

FIG. 3 illustrates a band structure of a conduction band in the semiconductor device illustrated in FIG. 2 in the case where a Si delta-doped layer is not formed between a cap layer and an etching stopper layer;

FIG. 4 illustrates a band structure of a conduction band in the semiconductor device illustrated in FIG. 2;

FIGs. 5A and 5B are sectional views illustrating an example of a process for manufacturing a semiconductor device according to this embodiment (part 1);

FIGs. 5C and 5D are sectional views illustrating an example of a process for manufacturing a semiconductor device according to this embodiment (part 2);

FIGs. 5E and 5F are sectional views illustrating an example of a process for manufacturing a semiconductor device according to this embodiment (part 3);

FIGs. 5G and 5H are sectional views illustrating an example of a process for manufacturing a semiconductor device according to this embodiment (part 4);

FIGs. 5I and 5J are sectional views illustrating an example of a process for manufacturing a semiconductor device according to this embodiment (part 5);

FIG. 5K is a sectional view in the case where etching time is controlled so that etching stops in a bulk of a non-doped InP barrier layer;

FIGs. 5L and 5M are sectional views illustrating an example of a process for manufacturing a semiconductor device according to this embodiment (part 6);

FIG. 6 is a sectional view illustrating a modification of a semiconductor device according to this embodiment; and

FIG. 7 illustrates a band structure of a conduction band in the modification of the semiconductor device illustrated in FIG. 6.

DESCRIPTION OF EMBODIMENTS

First of all, the related art are discussed. It is difficult to further shorten the delay time of transistors by decreasing the gate length or improving the material of a channel layer. For example, the contact resistance of a source electrode and a drain electrode constituting a transistor also serves as parasitic resistance, and thus the contact resistance is one of causes that affect the delay time.

According to the embodiments described below, the delay time of transistors is further shortened and signals are transmitted at high speed.

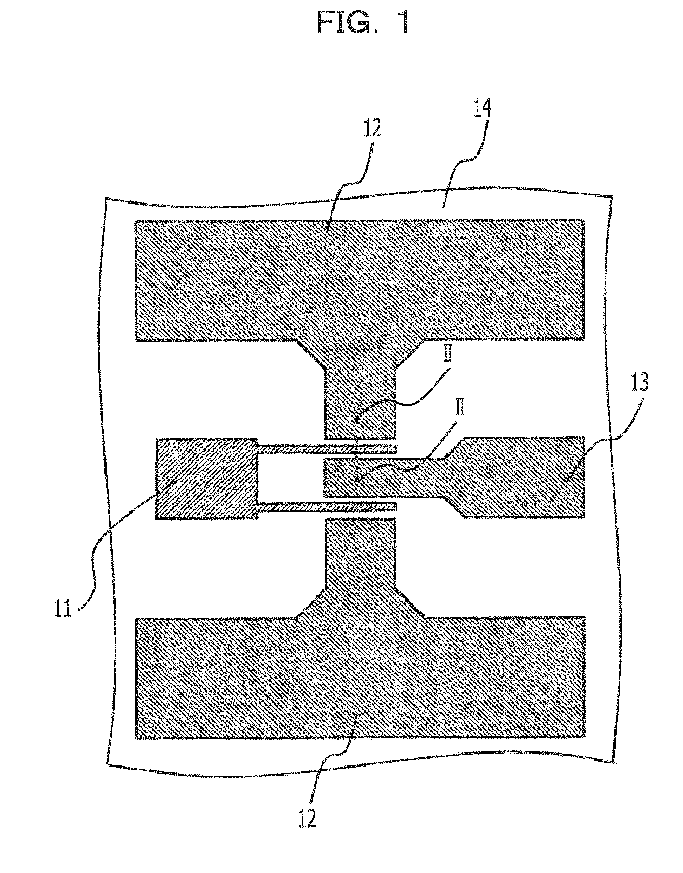

Embodiments will now be described with reference to FIGs. 1 to 4.

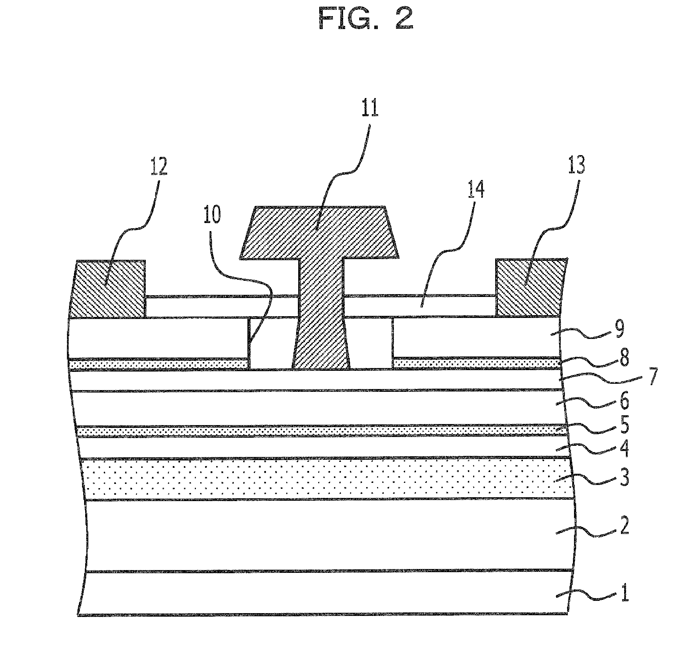

FIGs. 1 and 2 illustrate an example of a semiconductor device according to this embodiment. FIG. 1 is a plan view illustrating an example of a semiconductor device according to an embodiment. FIG. 2 is a sectional view taken along alternate long and short dashed line II-II illustrated in FIG. 1.

In this embodiment, as illustrated in FIG. 2, a non-doped InAlAs buffer layer 2 having a thickness of, for example, about 200 nm, a non-doped InGaAs channel layer 3 having a thickness of about 10 nm, a non-doped InAlAs spacer layer 4 having a thickness of about 3 nm, a Si delta-doped layer 5, a non-doped InAlAs barrier layer 6 having a thickness of about 6 nm, and a non-doped InP barrier layer 7 having a thickness of about 3 nm are formed on a semi-insulating InP substrate 1 having a thickness of, for example, 600 $\mu$m in that order.

The non-doped InGaAs channel layer 3 is used as an electron transit layer through which two-dimensional electron gas (2DEG) transits. The non-doped InAlAs spacer layer 4, the Si delta-doped layer 5, and the non-doped InAlAs barrier layer 6 are used as electron supply layers that supply electrons to the non-doped InGaAs channel layer 3. The non-doped InP barrier layer 7 is used as an etching stopper layer when a recess described below is formed. The non-doped InP barrier layer 7 also has a function as a protective film that inhibits the oxidation of Al in the non-doped InAlAs barrier layer 6.

An n-type InGaAs cap layer 9 having a thickness of about 20 nm is formed on the non-doped InP barrier layer 7. The n-type InGaAs cap layer 9 is doped with, for example, Si in a concentration of about $2 \times 10^{19}$ cm$^{-2}$,

A Si delta-doped layer 8 in which Si is doped in a sheet-like shape is formed between the non-doped InP barrier layer 7 and the n-type InGaAs cap layer 9. Furthermore, an opening 10 is formed in the n-type InGaAs cap layer 9 so as to penetrate through the n-type InGaAs cap layer 9 and the Si delta-doped layer 8 and expose part of the non-doped InP barrier layer 7. The depressed portion formed by the opening 10 is called a recess.

A gate electrode 11 is formed on the non-doped InP barrier layer 7 in the opening 10. The gate electrode 11 is disposed so as to be away from the Si delta-doped layer 8 and is in Schottky contact with the non-doped InP barrier layer 7.

A source electrode 12 and a drain electrode 13 are formed on the n-type InGaAs cap layer 9. The source electrode 12 and drain electrode 13 are in ohmic contact with the n-type InGaAs cap layer 9.

Furthermore, for example, an insulating film 14 is formed on the n-type InGaAs cap layer 9 in a region where the source electrode 12 and drain electrode 13 are not formed. The gate electrode 11 is formed so as to protrude from an opening of the insulating film 14.

Herein, the signal delay which poses a problem in semiconductor devices will be described. The total delay time $t_{total}$ of semiconductor devices is represented by the sum of the intrinsic delay time $t_{intrinsic}$ and the extrinsic delay time $t_{extrinsic}$.

$$\tau_{total} = \tau_{int\,rinsic} + \tau_{extrinsic} \quad (1)$$

The intrinsic delay time is represented by formula (2) below.

$$\tau_{int\,rinsic} = \frac{L_g}{2\pi v} \quad (2)$$

As represented by the formula (2), the intrinsic delay time is shortened by decreasing the gate length $L_g$ or increasing the electron speed v.

The extrinsic delay time is dependent on the contact resistance of a source electrode and a drain electrode and the sheet resistance caused by two-dimensional electron gas that flows between a source electrode and a gate electrode and between a gate electrode and a drain electrode. The sheet resistance is mainly dependent on the mobility and electron density of two-dimensional electron gas in a grown epitaxial crystal. The contact resistance is affected by an energy band structure from a cap layer to a channel layer through a barrier layer.

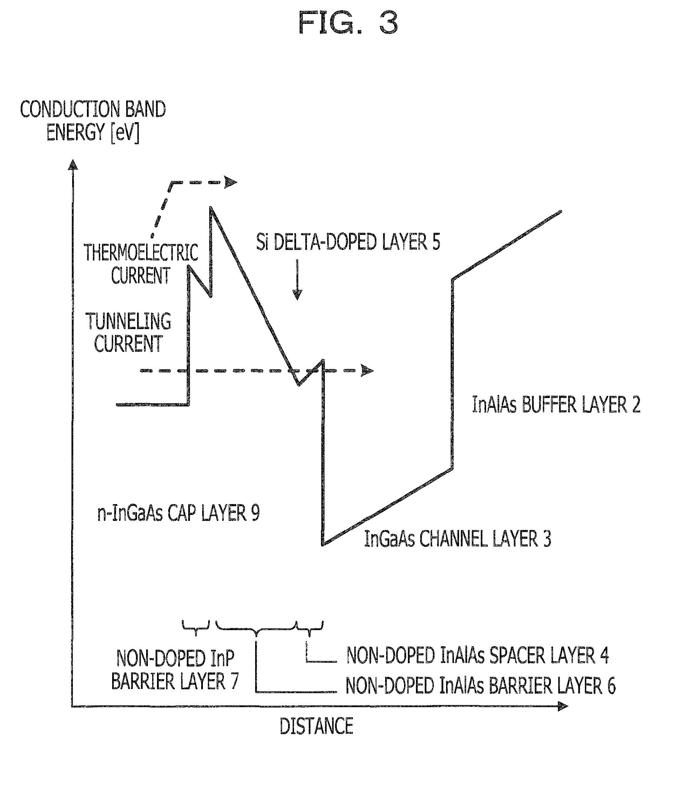

The band structure of a conduction band in the semiconductor device will now be described with reference to FIG. 3.

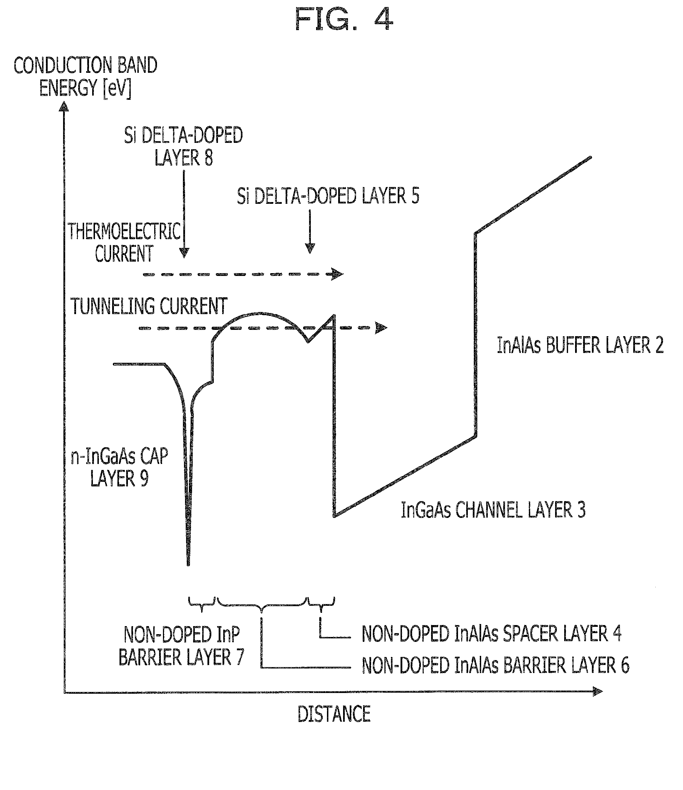

FIGs. 3 and 4 each illustrate an example of a band structure of a conduction band in the semiconductor device. FIG. 3 illustrates a band structure of a conduction band in the semiconductor device illustrated in FIG. 2 in the case where the Si delta-doped layer 8 is not formed. FIG. 4 illustrates a band structure of a conduction band in the semiconductor device illustrated in FIG. 2.

As illustrated in FIG. 3, the energy of the non-doped InAlAs barrier layer 6 on the n-type InGaAs cap layer 9 side and the energy of the non-doped InP barrier layer 7 are higher than that of the n-type InGaAs cap layer 9, which forms an energy barrier that obstructs electron flow from the n-type InGaAs cap layer 9 to the non-doped InGaAs channel layer 3. Therefore, electrons that flow from a source electrode through the n-type InGaAs cap layer 9 cross the non-doped InP barrier layer 7 and non-doped InAlAs barrier layer 6 each having a high conduction band energy level in the form of a thermoelectric current, or flow into the non-doped InGaAs channel layer 3 in the form of a tunneling current in which electrons pass through the non-doped InAlAs barrier layer 6 due to a quantum-mechanical tunnel effect. However, since the above-described energy barrier is present in the band structure illustrated in FIG. 3, few electrons are able to cross the non-doped InP barrier layer 7 and the non-doped InAlAs barrier layer 6 in the form of a thermoelectric current and thus a tunneling current contributes as an electric current that flows between the n-type InGaAs cap layer 9 and the non-doped InGaAs channel layer 3.

In contrast, in the case where the Si delta-doped layer 8 is formed between the non-doped InP barrier layer 7 and the n-type InGaAs cap layer 9 as illustrated in FIG. 4, the conduction band near the Si delta-doped layer 8 is bent and the energy is considerably reduced. In other words, the conduction band energy between the n-type InGaAs cap layer 9 and the non-doped InGaAs channel layer 3 is reduced, and electrons easily pass through the barrier layers in the form of not a tunneling current but also a thermoelectric current.

A thermoelectric current flows when electrons cross an energy barrier, and thus is expressed as an Arrhenius plot. The thermoelectric current $E_{previous}$ that flows in the case where the Si delta-doped layer 8 is not formed in the semiconductor device illustrated in FIGs. 1 and 2 is represented by formula (3) below.

$$I_{previous}^{th} \propto \exp(-E_{previous} / k_B T) \quad (3)$$

Herein, $k_B$ represents a Boltzmann constant and T represents the absolute temperature.

The thermoelectric current $E_{present}$ that flows in the semiconductor device illustrated in FIG. 2 is represented by formula (4) below.

$$I_{present}^{th} \propto \exp(-E_{present} / k_B T) \quad (4)$$

Thus, the ratio of the thermoelectric currents (increasing rate) is represented by formula (5) below from the formulae (3) and (4).

$$\frac{I_{present}^{th}}{I_{previous}^{th}} \cong \exp\left\{-\frac{\left(E_{present} - E_{previous}\right)}{k_B T}\right\} \quad (5)$$

Assuming that the amount of barrier height reduced: $E_{present}$-$E_{previous}$ = -0.2 eV, $k_B$ = 1.38 × 10^{-23}, and T = 300 K, the formula (5) is expressed as formula (6) below.

$$\frac{I_{present}^{th}}{I_{previous}^{th}} \cong \exp\left\{-\frac{\left(-0.2\right) \times 1.602 \times 10^{-19}}{1.38 \times 10^{-23} \times 300}\right\} \cong \exp(7.74) \cong 2300 \quad (6)$$

Thus, it is found that the thermoelectric current is considerably increased.

The tunneling current is increased because quantum-mechanical penetration of electrons into the barrier layers becomes easier due to a decrease in potential barrier. However, the increase in the tunneling current is not significant compared with the increase in the thermoelectric current.

According to this embodiment, the total amount of electric current that flows between a cap layer and a channel layer is increased due to a decrease in the conduction band energy in a barrier layer, which may reduce the contact resistance of a source electrode and a drain electrode. As a result, the extrinsic delay time may be shortened and high-speed operation of semiconductor devices may be achieved.

As illustrated in FIG. 2, the opening 10 is formed so as to penetrate through the n-type InGaAs cap layer 9 and the Si delta-doped layer 8. In this structure, the Si delta-doped layer 8 is not present directly below the gate electrode 11 and the gate electrode 11 is formed so as to be away from the Si delta-doped layer 8. The conduction band energy in a region where the Si delta-doped layer 8 is not present is higher than that in a region where the Si delta-doped layer 8 is present. Therefore, when the gate electrode 11 is formed in the region where the Si delta-doped layer 8 is not present, the non-doped InP barrier layer 7 functions as a Schottky barrier and thus the gate leakage current that flows from a channel layer to a gate electrode may be suppressed.

As described above, by forming an opening in a cap layer so as to penetrate through the cap layer and a Si delta-doped layer, the contact resistance may be reduced directly below a source electrode and a drain electrode and the gate leakage current may be suppressed directly below a gate electrode.

A method for manufacturing a semiconductor device according to an embodiment will now be described. Herein, the method is described using the sectional view taken along alternate long and short dashed line II-II illustrated in FIG. 1.

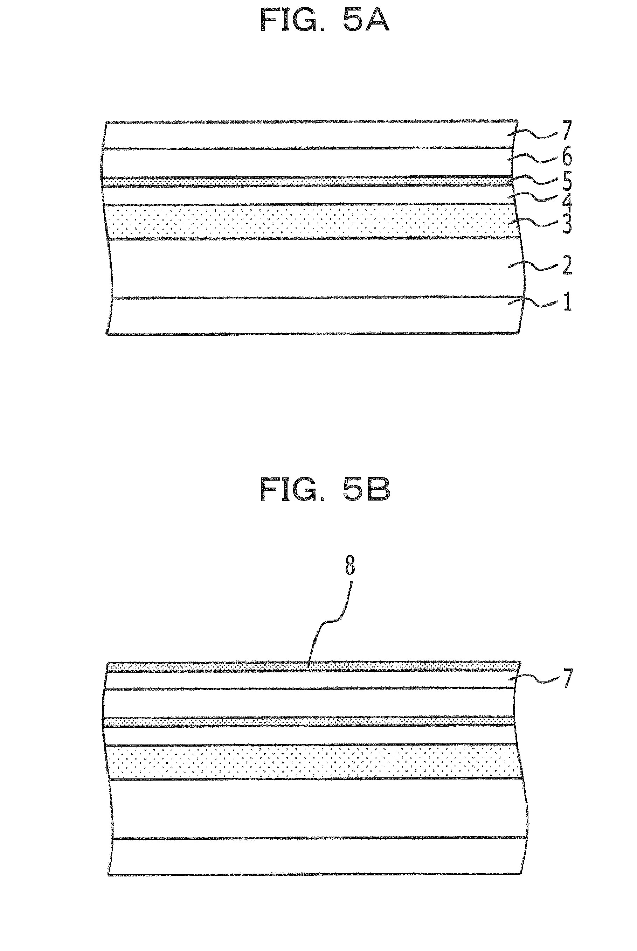

FIGs. 5A to 5M are sectional views illustrating an example of a method for manufacturing a semiconductor device according to this embodiment.

As illustrated in FIG. 5A, a non-doped $In_{0.52}Al_{0.48}As$ buffer layer 2 having a thickness of about 200 nm, a non-doped InGaAs channel layer 3 having a thickness of about 10 nm, a non-doped $In_{0.52}Al_{0.48}As$ spacer layer 4 having a thickness of about 3 nm, a Si-$\delta$ (delta)-doped layer 5, a non-doped InAlAs barrier layer 6 having a thickness of about 6 nm, and a non-doped InP barrier layer 7 having a thickness of about 3 nm are formed on a semi-insulating InP substrate 1 in that order by, for example, a molecular beam epitaxy (MBE) method.

Subsequently, as illustrated in FIG. 5B, an upper portion of the non-doped InP barrier layer 7 is doped with Si in a sheet-like shape (Si delta-doped layer 8). The doping of the upper portion of the non-doped InP barrier layer 7 with Si is preferably Si delta doping to uniformly decrease a potential barrier in an electric current channel and to suppress the formation of crystal defects. The doping amount in the case of Si delta doping is, for example, preferably about $5 \times 10^{12}$ $cm^{-2}$ to $1 \times 10^{13}$ $cm^{-2}$. If the doping amount is less than $5 \times 10^{12}$ $cm^{-2}$, the bending of a conduction band becomes small and the delay time caused by parasitic resistance is increased. If the doping amount is more than $1 \times 10^{13}$ $cm^{-2}$, crystal defects caused by Si delta doping are easily formed.

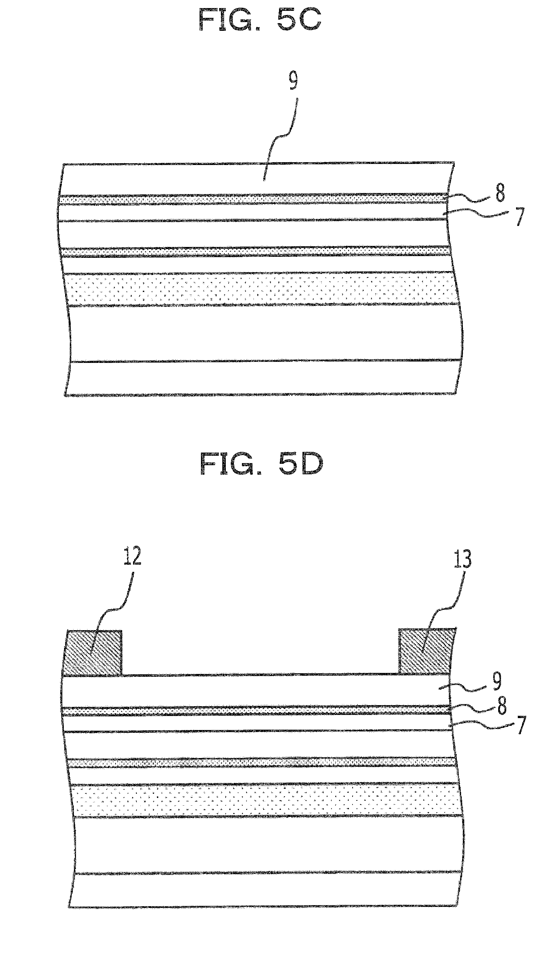

Next, as illustrated in FIG. 5C, an n-type $In_{0.53}Ga_{0.47}As$ cap layer 9 having a thickness of about 20 nm is formed on the Si delta-doped layer 8.

Next, semiconductor devices adjacent to each other are electrically separated from each other by, for example, a method in which a mesa structure is formed at the boundary between the semiconductor devices adjacent to each other. As illustrated in FIG. 5D, a source electrode 12 and a drain electrode 13 are then formed by, for example, photolithography. The source electrode 12 and drain electrode 13 may each be constituted by Ti/Pt/Au layers from the bottom.

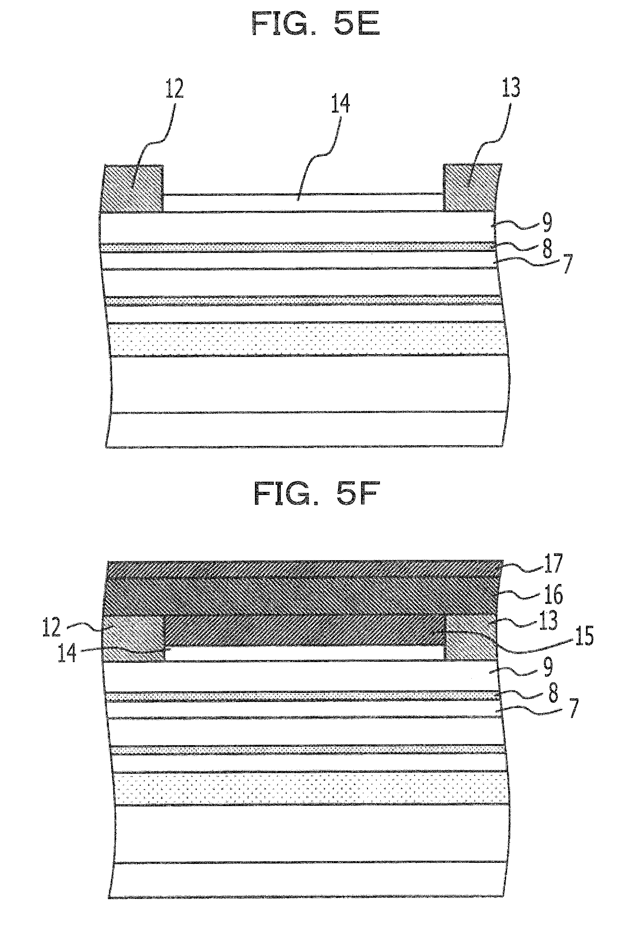

Subsequently, as illustrated in FIG. 5E, an insulating film 14 having a thickness of, for example, about 20 nm is formed by, for example, plasma chemical vapor deposition (plasma CVD) on the n-type cap layer 9 which is exposed between the source electrode 12 and the drain electrode 13.

Next, as illustrated in FIG. 5F, a first photoresist film 15, a second photoresist film 16, and a third photoresist film 17 are stacked on the source electrode 12, drain electrode 13, and insulating film 14 in that order. The second photoresist film 16 is formed of a photoresist having an exposure sensitivity higher than those of the first photoresist film 15 and third photoresist film 17. For example, the first photoresist film 15 serving as a lower layer and the third photoresist film 17 serving as an upper layer are formed of ZEP manufactured by ZEON CORPORATION, and the second photoresist film 16 serving as an intermediate layer is formed of PMGI manufactured by Microlithography Chemical Corporation (MCC). For example, the first photoresist film 15 has a thickness of about 200 nm, the second photoresist film 16 has a thickness of about 450 nm, and the third photoresist film 17 has a thickness of about 250 nm.

Portions of the second photoresist film 16 and third photoresist film 17 above a region where a gate electrode is to be formed are then irradiated with electron beams using an electron beam exposure apparatus. When the irradiation with electron beams is performed, for example, at an acceleration voltage of 50 kV in an irradiation dose of 100 μC/cm, the first photoresist film 15 serving as a lowermost layer is hardly exposed, and the second photoresist film 16 serving as an intermediate layer and the third photoresist film 17 serving as an uppermost layer may be exposed.

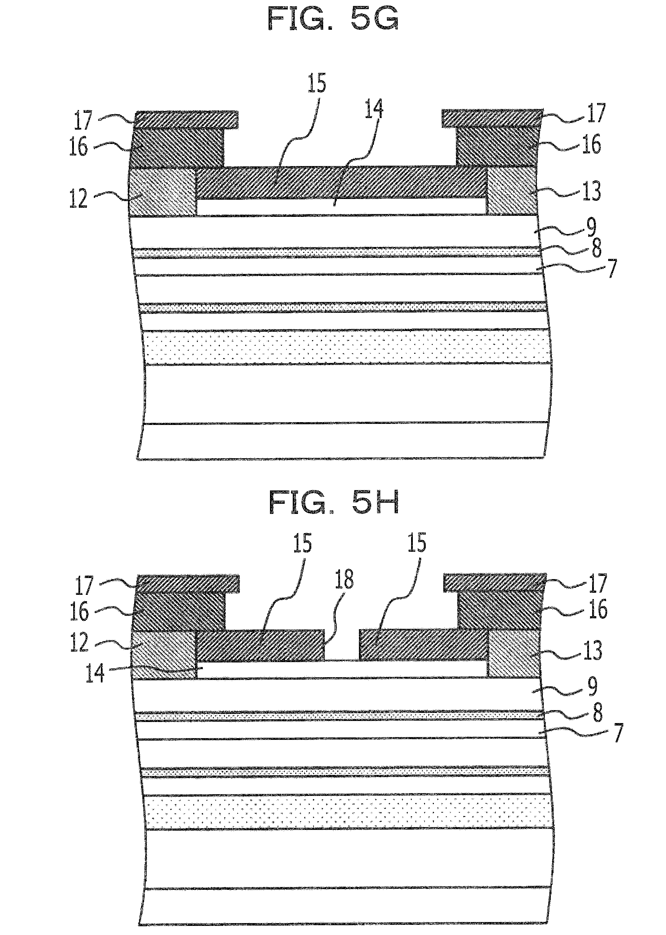

The third photoresist film 17 is developed using a mixed solution (high sensitivity developing solution) of, for example, methyl isobutyl ketone and methyl ethyl ketone, and the second photoresist film 16 is then developed using SD1 manufactured by Shipley Co. Thus, as illustrated in FIG. 5G, the portions of the second photoresist film 16 and third photoresist film 17 above a region where a gate electrode 11 is to be formed are removed. Since the sensitivity of the second photoresist film 16 is higher than that of the third photoresist film 17 as described above, the opening width of the second photoresist film 16 serving as an intermediate layer is larger than that of the third photoresist film 17 serving as an upper layer.

Subsequently, an opening is formed in the first photoresist film 15 serving as a lower layer. A region where an opening is to be formed is irradiated with electron beams using an electron beam exposure apparatus, for example, at an acceleration voltage of 50 kV in an irradiation dose of 1 nC/cm. The first photoresist film 15 is then developed using a mixed solution (low sensitivity developing solution) of methyl isobutyl ketone and isopropyl alcohol. Consequently, an opening 18 in which the insulating film 14 is exposed may be formed as illustrated in FIG. 5H.

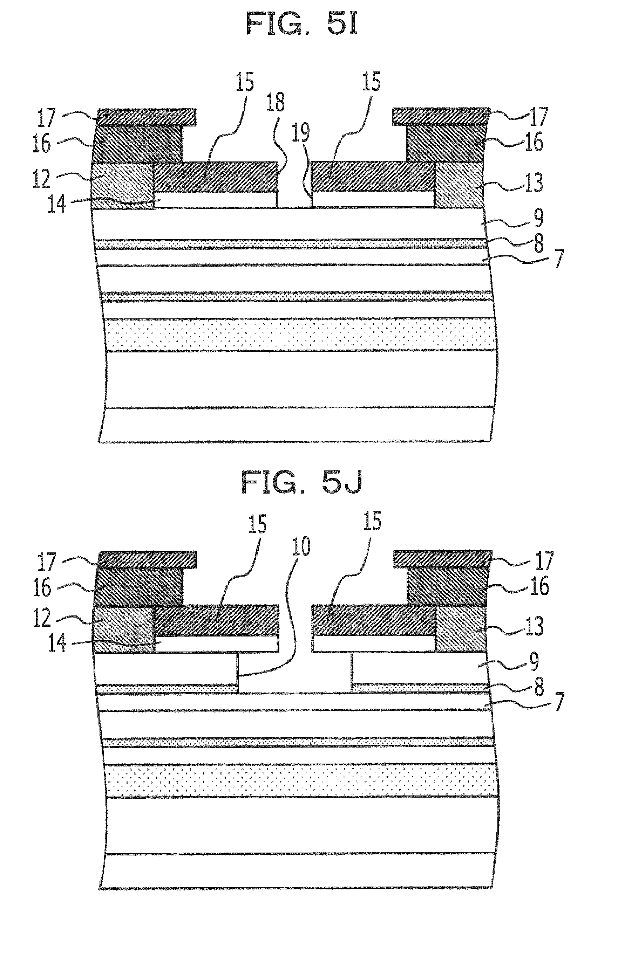

Next, as illustrated in FIG. 5I, the insulating film 14 is removed by, for example, etching using the first photoresist film 15 as a mask. Thus, an opening 19 that penetrates through the insulating film 14 is formed, and the n-type $In_{0.53}Ga_{0.47}As$ cap layer 9 is exposed. In the case where the insulating film 14 is included $SiO_2$, the etching is preferably performed by reactive ion etching using $CF_4$ gas or the like.

Subsequently, as illustrated in FIG. 5J, the n-type $In_{0.53}Ga_{0.47}As$ cap layer 9 and the Si delta-doped layer 8 are removed by being dissolved by, for example, wet etching (recess etching) using the first photoresist film 15 and the insulating film 14 as masks. Thus, an opening 10 that penetrates through the n-type InGaAs cap layer 9 and the Si delta-doped layer 8 and exposes the non-doped InP barrier layer 7 is formed.

A mixed solution containing, for example, citric acid ($C_6H_8O_7$) and a hydrogen peroxide solution ($H_2O_2$) is employed as an etching solution used in the recess etching. The mixed solution may be produced as follows. A citric acid solution containing, for example, citric acid and water at a ratio of citric acid:water = 1:2 by mass is prepared. The prepared citric acid solution and a hydrogen peroxide solution are mixed with each other so that citric acid solution: hydrogen peroxide solution = 1:1 by volume is achieved.

In the case where the mixed solution containing citric acid and a hydrogen peroxide solution is used, the etching rate in the n-type InGaAs cap layer 9 is about 80 nm/min, the etching rate in the non-doped InAlAs barrier layer 6 is about 8 nm/min, and the etching rate in the non-doped InP barrier layer 7 is about 0.8 nm/min. Therefore, when etching is performed using the mixed solution containing citric acid and a hydrogen peroxide solution, the etching rates in the non-doped InP barrier layer 7 and the non-doped InAlAs barrier layer 6 become low after the n-type InGaAs cap layer 9 is subjected to recess etching. Thus, the etching time control for stopping etching at a desired position is relatively easily performed, and it is easy to selectively remove the Si delta-doped layer 8.

When recess etching is performed, the etching time may also be controlled so that the recess etching does not stop near the interface between the non-doped InP barrier layer 7 and the n-type InGaAs cap layer 9 but stops in the non-doped InP barrier layer 7.

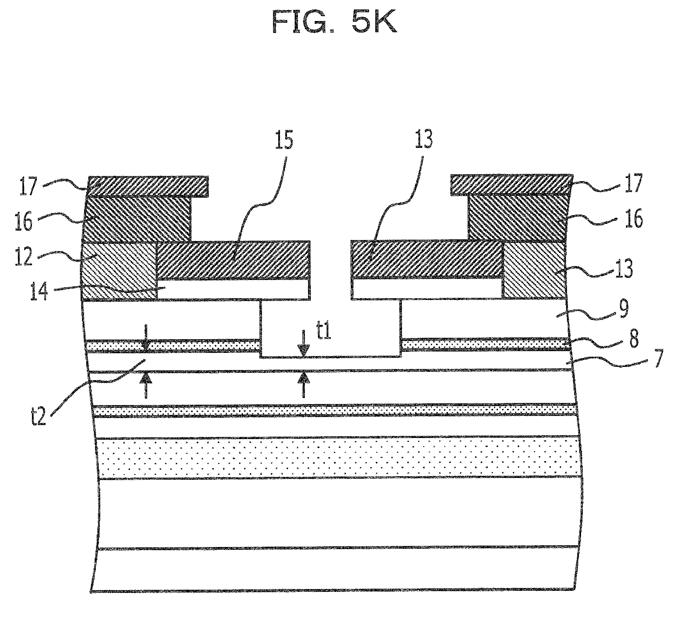

FIG. 5K is a sectional view in the case where the etching time is controlled so that the etching stops in the non-doped InP barrier layer 7. As illustrated in FIG. 5K, the thickness t1 of the non-doped InP barrier layer 7 in a region exposed by etching is smaller than the thickness t2 of the non-doped InP barrier layer 7 in a region where the Si delta-doped layer 8 is formed, that is, the opening 10 is not formed. By employing this method, the permissible precision range of etching depth in an etching process is increased. Therefore, part of the Si delta-doped layer 8 is not left due to, for example, lack of etching to cause defects and the production yield of semiconductor devices is increased.

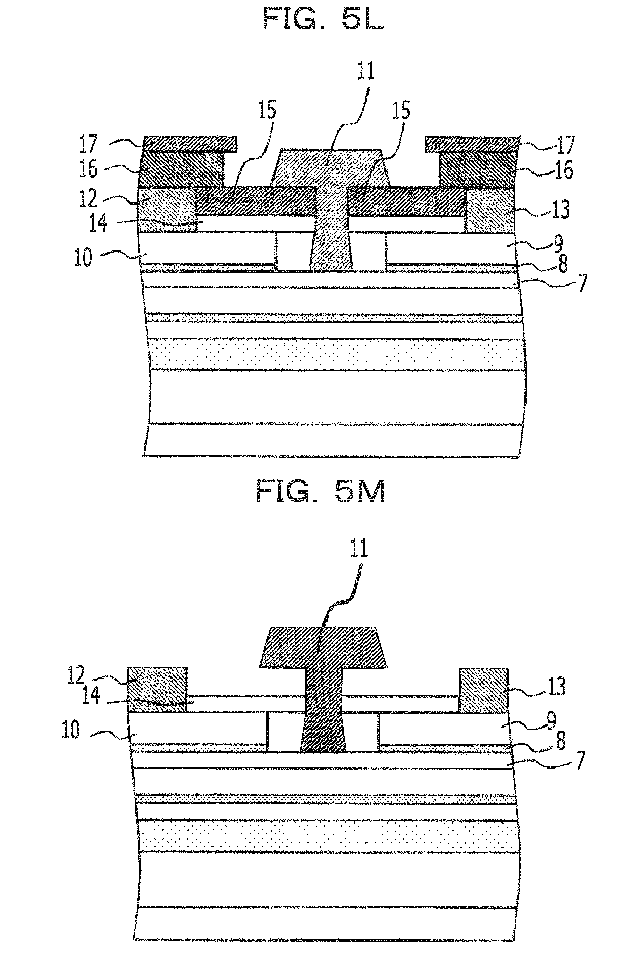

Next, as illustrated in FIG. 5L, Ti/Pt/Au layers collectively serving as a gate electrode 11 are formed in that order by, for example, a vacuum deposition method and a lift-off method. As a result, a gate electrode 11 electrically coupled to the non-doped InP barrier layer 7 through the openings 18 and 19 is formed.

After the third photoresist film 17 and the second photoresist film 16 are removed, the first photoresist film 15 is further removed. Accordingly, a semiconductor device according to this embodiment that is illustrated in FIG. 5M may be produced.

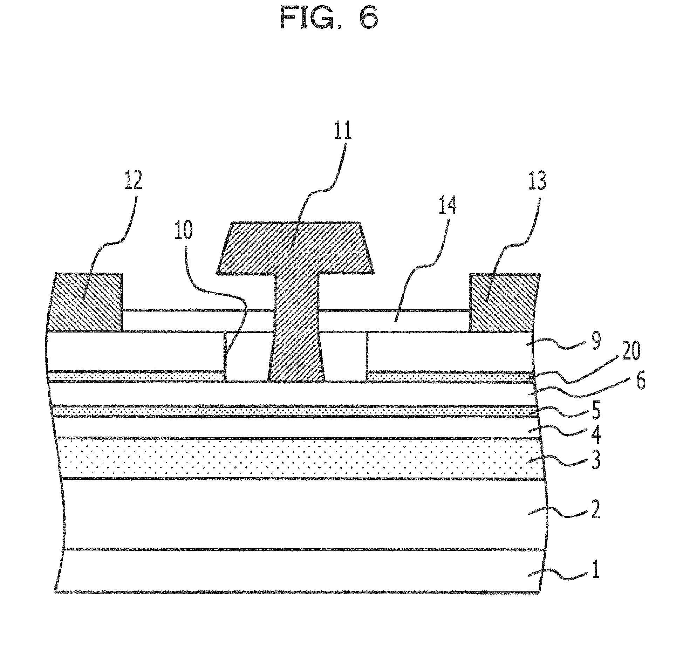

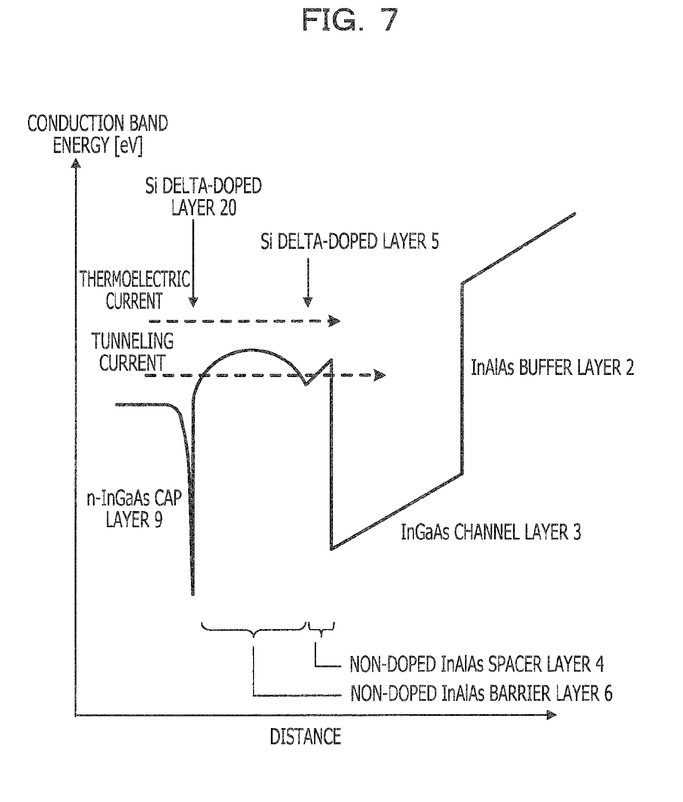

A modification of the semiconductor device according to this embodiment will now be described with reference to FIGs. 6 and 7.

FIG. 6 is a sectional view illustrating a modification of the semiconductor device according to this embodiment and is also a sectional view taken along alternate long and short dashed line II-II illustrated in FIG. 1. In FIG. 6, the same parts as those in FIG. 2 are designated by the same reference numerals, and the description thereof is omitted.

In the modification, as illustrated in FIG. 6, the non-doped InP barrier layer 7 is not present between the non-doped InAlAs barrier layer 6 and the n-type InGaAs cap layer 9, and a Si delta-doped layer 20 is formed in a portion of the non-doped InAlAs barrier layer 6 on the n-type InGaAs cap layer 9 side.

Furthermore, an opening 10 that penetrates through the n-type InGaAs cap layer 9 and the Si delta-doped layer 20 and exposes part of the non-doped InAlAs barrier layer 6 is formed in the n-type InGaAs cap layer 9.

A gate electrode 11 is formed on the non-doped InAlAs barrier layer 6 exposed in the opening 10. The gate electrode 11 is disposed so as to be away from the Si delta-doped layer 20 and is in Schottky contact with the non-doped InAlAs barrier layer 6. A structure of layers formed above the n-type InGaAs cap layer 9 is substantially the same as that illustrated in FIG. 2.

FIG. 7 illustrates a band structure of a conduction band in the semiconductor device illustrated in FIG. 6. In the case where the Si delta-doped layer 20 is formed in a portion of the non-doped InAlAs barrier layer 6 on the n-type InGaAs cap layer 9 side, as illustrated in FIG. 7, the conduction band near the Si delta-doped layer 20 is bent and the energy is considerably reduced.

Also in the modification, since the conduction band energy between a cap layer and a channel layer is reduced, the total amount of electric current flowing between the cap layer and the channel layer is increased. Consequently, the contact resistance may be reduced.

The embodiments have been described in detail so far, but are not limited to examples described and various modifications and changes may be made. For example, in the embodiment illustrated in FIG. 2, the opening 10 that penetrates through the Si delta-doped layer 8 and the n-type InGaAs cap layer 9 so as to have substantially the same opening area has been described. However, the gate electrode 11 may be simply formed so as to be away from the Si delta-doped layer 8. The opening area of the Si delta-doped layer 8 may be smaller than that of the n-type InGaAs cap layer 9.

Alternatively, a semiconductor device included materials different from those in the disclosed embodiment may be employed as a modification. For example, in a semiconductor device including a channel layer included GaAs, a barrier layer included AlGaAs, and a cap layer included n-type GaAs, a Si delta-doped layer may be formed between the barrier layer and the cap layer. In a semiconductor device including a channel layer included InGaAs, a barrier layer included AlGaAs, and a cap layer included n-type InGaAs, a Si delta-doped layer may be formed between the barrier layer and the cap layer. In a semiconductor device including a channel layer included InGaAs, a barrier layer included AlGaAs, and a cap layer constituted by a layer included n-type InGaAs, n-type GaAs, or n-type InGaAs and a layer included n-type GaAs, a Si delta-doped layer may be formed between the barrier layer and the cap layer. In a semiconductor device including a channel layer included GaN, a barrier layer included AlGaN or InAlN, and a cap layer included n-type GaN, a Si delta-doped layer may be formed between the barrier layer and the cap layer.

Alternatively, a high-concentration Si doped region may be formed in a portion of a barrier layer near a cap layer, a portion of a cap layer near a barrier layer, or both the portions. By increasing the Si doping amount in the portion of the cap layer near the barrier layer to be higher than the Si doping amount in an n-type cap layer, the conduction band energy may be reduced also in the cap layer, and thus the contact resistance may be reduced.

**Claims**

1. A semiconductor device comprising:

   a carrier transit layer above a substrate;
   a carrier supply layer above the carrier transit layer;
   an etching stopper layer above the carrier supply layer, the etching stopper layer being coupled to a gate electrode; and
   a cap layer above the etching stopper layer, the cap layer being coupled to each of a source electrode and a drain electrode and having a conduction band energy lower than that of the etching stopper layer,
   wherein a portion of the etching stopper layer on the cap layer includes Silicon.

2. The semiconductor device according to claim 1,
   wherein the portion has an opening, and
   the gate electrode is in Schottky contact with the etching stopper layer in a region where the etching stopper layer is exposed in the opening.

3. The semiconductor device according to claim 2,
   wherein a thickness of a portion of the etching stopper layer adjacent to the opening is smaller than a thickness of another portion of the etching stopper layer including Silicon.

4. A semiconductor device comprising:

   a carrier transit layer above a substrate;
   a carrier supply layer above the carrier transit layer, the carrier supply layer being coupled to a gate electrode; and
   a cap layer above the carrier supply layer, the cap layer being coupled to each of a source electrode and a drain electrode and having a conduction band energy lower than that of the carrier supply layer,

wherein a portion of the carrier supply layer on the cap layer includes Silicon.

5. The semiconductor device according to claim 4,
wherein the portion has an opening, and
the gate electrode is in Schottky contact with the carrier supply layer in a region where the carrier supply layer is exposed in the opening.

6. The semiconductor device according to claim 5,
wherein a thickness of a portion of the carrier supply layer adjacent to the opening is smaller than a thickness of another portion of the carrier supply layer including Silicon.

7. A method for manufacturing a semiconductor device, the method comprising:

forming a carrier transit layer above a substrate;
forming a carrier supply layer above the carrier transit layer;
forming an etching stopper layer above the carrier supply layer;
forming a Silicon doped layer in an upper portion of the etching stopper layer;
forming a cap layer above the Silicon doped layer, the cap layer having a conduction band energy lower than that of the etching stopper layer;
forming a source electrode and a drain electrode above the cap layer;
forming an opening through the Silicon doped layer; and
forming a gate electrode in a region where the etching stopper layer is exposed in the opening, the gate electrode being coupled to the etching stopper layer.

8. The method according to claim 7,
wherein the opening is formed so as to penetrate through the cap layer.

9. The method according to claim 8,
wherein the opening is formed so that a thickness of a portion of the etching stopper layer adjacent to the opening is smaller than a thickness of another portion of the etching stopper layer doped with Si.

10. A method for manufacturing a semiconductor device, comprising:

forming a carrier transit layer above a substrate;
forming a carrier supply layer above the carrier transit layer;
forming a Si doped layer in an upper portion of the carrier supply layer;
forming a cap layer above the Silicon doped layer, the cap layer having a conduction band energy lower than that of the carrier supply layer;
forming a source electrode and a drain electrode above the cap layer;
forming an opening through the Silicon doped layer; and
forming a gate electrode in a region where the carrier supply layer is exposed in the opening, the gate electrode being in Schottky contact with the carrier supply layer.

11. The method according to claim 10,
wherein the opening is formed so as to penetrate through the cap layer.

12. The method according to claim 11,
wherein the opening is formed so that a thickness of a portion of the carrier supply layer adjacent to the opening is smaller than a thickness of another portion of the carrier supply layer doped with Silicon.

# FIG. 1

FIG. 2

# FIG. 3

CONDUCTION BAND
ENERGY [eV]

THERMOELECTRIC
CURRENT

Si DELTA-DOPED LAYER 5

TUNNELING
CURRENT

InAlAs BUFFER LAYER 2

n-InGaAs CAP LAYER 9

InGaAs CHANNEL LAYER 3

NON-DOPED InP
BARRIER LAYER 7

NON-DOPED InAlAs SPACER LAYER 4
NON-DOPED InAlAs BARRIER LAYER 6

DISTANCE

# FIG. 4

CONDUCTION BAND
ENERGY [eV]

Si DELTA-DOPED
LAYER 8

Si DELTA-DOPED LAYER 5

THERMOELECTRIC
CURRENT

TUNNELING CURRENT

InAlAs BUFFER LAYER 2

n-InGaAs CAP
LAYER 9

InGaAs CHANNEL LAYER 3

NON-DOPED InP
BARRIER LAYER 7

NON-DOPED InAlAs SPACER LAYER 4

NON-DOPED InAlAs BARRIER LAYER 6

DISTANCE

# FIG. 5A

# FIG. 5B

# FIG. 5C

9

8
7

# FIG. 5D

12
13

9
8
7

# FIG. 5E

# FIG. 5F

# FIG. 5G

# FIG. 5H

# FIG. 5I

# FIG. 5J

# FIG. 5K

# FIG. 5L

# FIG. 5M

FIG. 6

# FIG. 7

CONDUCTION BAND ENERGY [eV]

Si DELTA-DOPED LAYER 20

Si DELTA-DOPED LAYER 5

THERMOELECTRIC CURRENT

TUNNELING CURRENT

InAlAs BUFFER LAYER 2

n-InGaAs CAP LAYER 9

InGaAs CHANNEL LAYER 3

NON-DOPED InAlAs SPACER LAYER 4

NON-DOPED InAlAs BARRIER LAYER 6

DISTANCE

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SEONG-JIN YEON et al.** 610 GHz In-AlAs/In0.75GaAs Metamorphic HEMTs with an Ultra-Short 15-nm-Gate. *IEDM Technical Digest,* 2007, 613-616
- **DAE-HYUN KIM et al.** 30-nm InAs PHEMTs With fT = 644 GHz and fmax = 681 GHz. *IEEE Electron Device Letters,* August 2010, vol. 31 (8), 806-808

- **A. LEUTHER et al.** 20 NM METAMORPHIC HEMT WITH 660 GHz FT. *Proc. IPRM 2011 (International Conference of Indium Phosphide and Related Materials 2011),* 2011, 295-298